# FASCICULE DE BREVET EUROPEEN

(11) **EP 3 920 204 B1**
(45) Date de publication et mention de la délivrance du brevet: **22.05.2024**
(21) Numéro de dépôt: 21177606.7
(22) Date de dépôt: 03.06.2021
(51) Int. Cl.: H01H 71/04

(54) **MÉTHODE ET DISPOSITIF DE DÉTECTION DU DÉCLENCHEMENT D'UN APPAREIL DE COUPURE, ET ARMOIRE ÉLECTRIQUE COMPRENANT UN TEL DISPOSITIF**
METHODE UND VORRICHTUNG ZUR ERKENNUNG DER AUSLÖSUNG EINES UNTERBRECHUNGSGERÄTS UND SCHALTSCHRANK, DER EINE SOLCHE VORRICHTUNG UMFASST
METHOD AND DEVICE FOR DETECTING THE ACTIVATION OF A CUT-OFF DEVICE, AND ELECTRICAL CABINET COMPRISING SUCH A DEVICE

(30) Priorité: 04.06.2020 FR 2005861
(43) Date de publication de la demande: 08.12.2021
(73) Titulaire: Schneider Electric Industries SAS, 92500 Rueil-Malmaison (FR)
(72) Inventeur: AGNAOU, Abderrahmane, 38100 GRENOBLE (FR); NEYRET, Yannick, 38330 BIVIERS (FR); GOUPIL, Laurent, 38110 LA TOUR DU PIN (FR)
(74) Mandataire: Lavoix

(56) Documents cités:
- EP-A1- 2 731 217
- WO-A1-2015/020653
- WO-A2-96/07192

## Description

La présente invention concerne une méthode et un dispositif de détection du déclenchement d'un appareil de coupure, ainsi qu'une armoire électrique comprenant un tel dispositif.

L'invention concerne plus généralement le domaine technique de la protection des installations électriques.

L'invention s'applique notamment aux appareils de gestion d'un courant électrique, par exemple des appareils de protection électrique destinés à couper un courant électrique, tels que des disjoncteurs à basse tension.

Des appareils de coupure sont commandés par un mécanisme d'actionnement piloté par un déclencheur et sont utilisés pour interrompre un courant électrique très rapidement dès l'apparition d'un défaut électrique. Généralement, ces appareils sont installés dans une armoire électrique aux côtés d'appareils de commutation comme des contacteurs et des télérupteurs qui, eux, sont commutés lorsqu'ils reçoivent un ordre de commutation émis par une entité extérieure à l'installation.

Il est souhaitable de pouvoir identifier rapidement lorsqu'un appareil de protection a été déclenché suite à un défaut électrique, par exemple afin d'intervenir manuellement, avec un électricien, pour réarmer l'appareil et, le cas échéant, supprimer le problème à l'origine du défaut électrique, tout en évitant d'envoyer un électricien pour une fausse alerte.

Il existe des appareils de protection équipés de systèmes de communication radio qui permettent d'envoyer des informations sur leur état. Ces solutions sont cependant coûteuses à mettre en oeuvre, notamment dans des installations comportant un grand nombre d'appareils, et il n'est pas toujours possible de les déployer sur des installations existantes lorsqu'on ne souhaite pas remplacer tous les appareils.

Le document WO 96/07192 A2 divulgue une méthode de détection du déclenchement d'un appareil de coupure dans une armoire de distribution selon le préambule de la revendication 1.

C'est à cet inconvénient qu'entend plus particulièrement remédier l'invention, en proposant une méthode de détection acoustique d'un déclenchement d'un appareil de coupure dans une armoire électrique et un dispositif de détection et une armoire électrique associés.

A cet effet, l'invention concerne une méthode de détection du déclenchement d'un appareil de coupure dans une armoire électrique, selon la revendication 1.

Selon des aspects avantageux mais non obligatoires, une telle méthode de détection peut incorporer une ou plusieurs des caractéristiques suivantes, prises isolément ou suivant toute combinaison techniquement admissible :
- le système d'apprentissage est un réseau de neurones ;
- la phase de détection comprend discrétiser le signal du bruit d'appareil acquis et comparer la valeur obtenue avec les catégories de prise de décision et si la valeur obtenue rentre dans une catégorie de prise de décision, envoyer un signal d'alarme ;
- lorsqu'un signal d'alarme est envoyé alors qu'aucun déclenchement ne s'est produit, le bruit enregistré à l'origine de l'alarme est utilisé pour modifier les catégories de prise de décision ;
- l'étape d'injection comprend l'injection d'un courant de coupure en surcharge, l'injection d'un courant différentiel et l'injection d'un courant de coupure en court-circuit pour simuler différents types de défauts électriques ;
- le système d'apprentissage automatique définit au moins un attribut statistique du signal de bruit de coupure acquis pour caractériser le bruit de l'appareil de coupure ;
- un ou plusieurs des attributs statistiques sont choisis dans le groupe comprenant :
   - la durée pendant laquelle l'intensité du signal de bruit de coupure reste supérieure à un pourcentage prédéterminé de l'intensité maximale du signal de bruit de coupure,
   - un point d'inflexion mesuré à un instant de temps prédéterminé avant l'atteinte d'un pourcentage prédéterminé de l'intensité maximale du signal de bruit de coupure,
   - une gamme de fréquence correspondant à une mesure de l'instant de la première atteinte du 100% de l'intensité du signal de bruit de coupure, ou une moyenne d'intensité du signal de bruit de coupure plus grande d'un pourcentage prédéterminé de l'intensité maximale du signal de bruit de coupure, et
   - une mesure de l'instant de la première atteinte du 100 % de l'intensité du signal de bruit de coupure ;
- le signal de bruit d'appareil est acquis en continu ;
- un des appareils de coupure est modifié pour produire un son spécifique lors du déclenchement, ce son spécifique étant préalablement appris dans la phase d'apprentissage ;

En outre, l'invention concerne un dispositif de détection du déclenchement d'un appareil de coupure dans une armoire électrique comprenant au moins un appareil de coupure du courant électrique et au moins un appareil de commutation du courant électrique, le dispositif de détection comprenant une unité de commande électronique configurée pour exécuter la méthode de détection du déclenchement selon l'une quelconque des revendications précédentes, une interface de communication connectée avec l'unité de commande électronique apte à émettre un signal d'alerte, et un microphone connecté avec l'unité de commande électronique apte à acquérir le signal de bruit d'appareil, le signal de bruit de coupure et le signal de bruit de commutation.

En outre, l'invention concerne une armoire électrique comprenant un dispositif comme décrit ci-dessus installé à l'intérieur de l'armoire électrique, en haut d'une colonne de l'armoire.

En outre, l'invention concerne une armoire électrique comprenant plusieurs colonnes, chaque colonne étant équipée d'un dispositif de détection comme décrit ci-dessus, installé en haut de l'armoire, avec le microphone déporté vers une zone à surveiller.

En outre, l'invention concerne une armoire électrique comprenant plusieurs colonnes où une seule colonne est équipée d'un dispositif de détection comme décrit ci-dessus, placé en haut de l'armoire, avec une pluralité de microphones déportés vers des zones à surveiller dans chaque colonne.

En outre, l'invention concerne une armoire électrique comprenant plusieurs colonnes dont certaines sont compartimentées, chaque compartiment comprenant un dispositif de détection selon comme décrit ci-dessus.

L'invention sera mieux comprise et d'autres avantages de celle-ci apparaîtront plus clairement à la lumière de la description qui va suivre, d'un mode de réalisation d'un appareil de protection électrique donné uniquement à titre d'exemple et faite en référence aux dessins annexés dans lesquels :
[Fig 1] la figure 1 représente schématiquement une armoire électrique contenant un dispositif de détection selon des modes de réalisation de la présente invention ;
[Fig 2] la figure 2 représente schématiquement un exemple du dispositif de détection de la figure 1 ;
[Fig 3] la figure 3 représente un diagramme de blocs illustrant des étapes de la méthode de détection du déclenchement d'un disjoncteur dans une armoire de distribution électrique selon des modes de réalisation de la présente invention ;
[Fig 4] la figure 4 est un graphique représentant un système de référence à plusieurs dimensions où des points symbolisent des valeurs qui représentent la caractérisation des bruits d'appareils de coupure et/ou de commutation utilisé pendant une phase préalable d'apprentissage du dispositif de détection de la figure 2 ;
[Fig 5] la figure 5 est un graphe représentant un exemple de bruit de déclenchement d'un appareil de coupure enregistré par le dispositif de détection de la figure 1 et sur lequel est défini un premier attribut statistique ;
[Fig 6] la figure 6 est un graphe représentant un exemple de bruit de déclenchement d'un appareil de coupure enregistré par le dispositif de détection de la figure 1 et sur lequel sont définis un deuxième et un troisième attribut statistique ;
[Fig 7] la figure 7 est un graphe représentant un exemple de bruit de déclenchement d'un appareil de coupure enregistré par le dispositif de détection de la figure 1 et sur lequel est défini un quatrième attribut statistique.

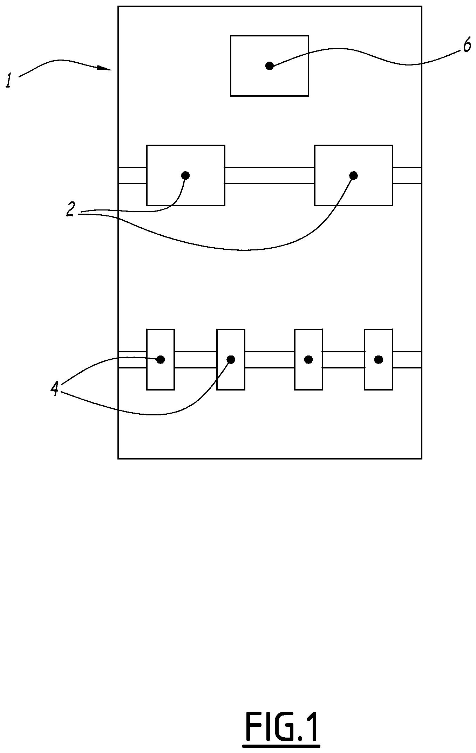

La figure 1 représente une armoire électrique 1 contenant plusieurs appareils de coupure du courant électrique 2, tel quel un disjoncteur, plusieurs appareils de commutation 4, tel qu'un contacteur ou un télérupteur, et un dispositif de détection acoustique 6 selon la présente invention.

Chaque appareil de coupure 2 ou appareil de commutation 4 permet de gérer un courant électrique circulant au sein d'une installation électrique à laquelle est associé l'appareil lui-même, de façon connue.

Par exemple, les appareils de coupure 2 sont pilotés par un déclencheur embarqué et sont utilisés pour interrompre un courant électrique très rapidement dès l'apparition d'un défaut électrique. En cela ils diffèrent des appareils de commutation 4 comme des contacteurs et des télérupteurs qui, eux, sont commutés lorsqu'ils reçoivent un ordre de commutation émis par une entité extérieure à l'installation.

En pratique, les appareils de coupure 2 et les appareils de commutation 4 sont des appareils électromécaniques comportant un mécanisme de commutation déplaçable entre un état fermé et un état ouvert afin d'autoriser ou d'interrompre sélectivement la circulation de courants électriques dans l'installation électrique. Chacun de ces appareils génère un bruit spécifique lors de la commutation, notamment lorsqu'il passe d'un état fermé vers l'état ouvert.

Le dispositif de détection acoustique 6 est notamment configuré pour détecter et reconnaître le bruit émis par la commutation d'un appareil de coupure 2, comme cela sera expliqué dans ce qui suit.

L'armoire électrique 1 définie ci-dessus désigne tous types de contenants pour appareils électriques notamment des armoires électriques, des tableaux électriques, des coffrets, des boîtes de raccordement, des goulottes ou des chemins de câbles. L'armoire électrique 1 est de préférence associée à une installation électrique, telle qu'une installation de distribution d'électricité.

De préférence, le dispositif de détection 6 est installé à l'intérieur de l'armoire électrique 1, dans une zone à surveiller, par exemple dans une colonne de l'armoire électrique 1, de préférence en haut de la colonne, et sera décrit en détail ci-dessous.

En variante, l'armoire électrique 1 comprend plusieurs colonnes, chaque colonne ayant son propre dispositif de détection 6.

Ces deux solutions sont préférables pour des armoires de taille réduite comme des coffrets.

En variante, l'armoire électrique 1 comprend plusieurs colonnes, chaque colonne étant équipée d'un dispositif de détection 6, installé de préférence en haut de l'armoire, avec un microphone déporté vers la zone à surveiller. Cette variante est adaptée pour des armoires de grande taille.

En variante, l'armoire électrique 1 comprend plusieurs colonnes et une seule colonne est équipée d'un dispositif de détection 6, de préférence placé en haut de l'armoire avec des microphones déportés vers les zones à surveiller dans chaque colonne. En d'autres termes, plusieurs microphones sont connectés au même dispositif de détection 6.

En variante, l'armoire électrique 1 comprend plusieurs colonnes dont certaines sont compartimentées, et chaque compartiment comprend un dispositif de détection 6 autonome. Le microphone n'est alors pas nécessairement déporté et peut être placé à l'intérieur d'un boîtier du dispositif de détection 6.

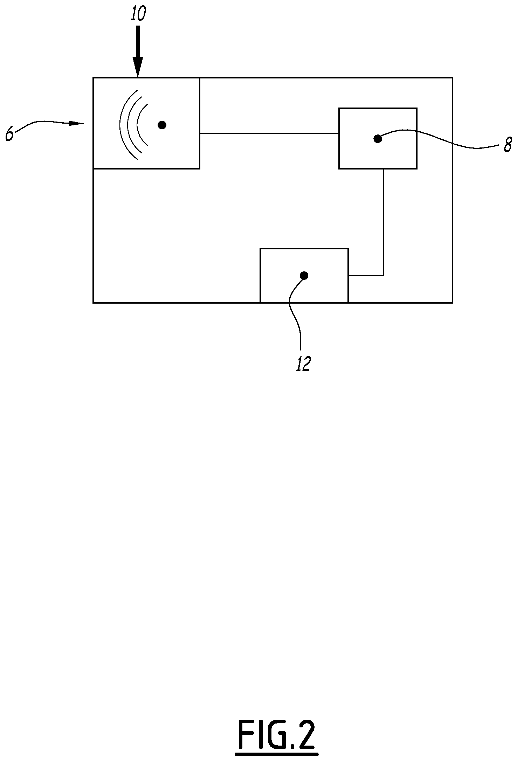

La figure 2 représente schématiquement un mode de réalisation du dispositif de détection 6, qui comprend une unité de commande électronique 8 pour le traitement des données, une interface de communication radio 10 connectée avec l'unité de commande électronique 8 et un microphone 12 connecté avec l'unité de commande électronique 8.

L'unité de commande électronique 8 est configurée pour exécuter une méthode de détection d'un déclenchement d'un appareil de coupure dans une armoire de distribution électrique selon la présente invention.

Par exemple, l'unité de commande 8 comporte un processeur, tel qu'un microcontrôleur programmable ou un microprocesseur, et une mémoire informatique formant un support d'enregistrement de données lisible par ordinateur.

Selon des exemples, la mémoire est une mémoire ROM, ou une mémoire RAM, ou une mémoire non volatile de type EPROM, ou EEPROM, ou Flash, ou NVRAM, ou une mémoire optique ou une mémoire magnétique.

La mémoire comporte des instructions exécutables et/ou un code logiciel pour mettre en oeuvre un procédé de détection acoustique d'un déclenchement d'un appareil de coupure électrique lorsque ces instructions sont exécutées par le processeur.

Selon des variantes, l'unité de commande 8 peut comporter un processeur de traitement du signal (DSP), ou un composant logique reprogrammable (FPGA), ou un circuit intégré spécialisé (ASIC), ou tout circuit électronique équivalent.

L'interface de communication radio 10 peut être configurée pour implémenter une liaison radio de courte portée de type Bluetooth^{®} ou Zigbee^{®}, ou une liaison radio de type WiFi, ou une liaison de télécommunications de type 3G, ou 4G, ou 5G, ou équivalent

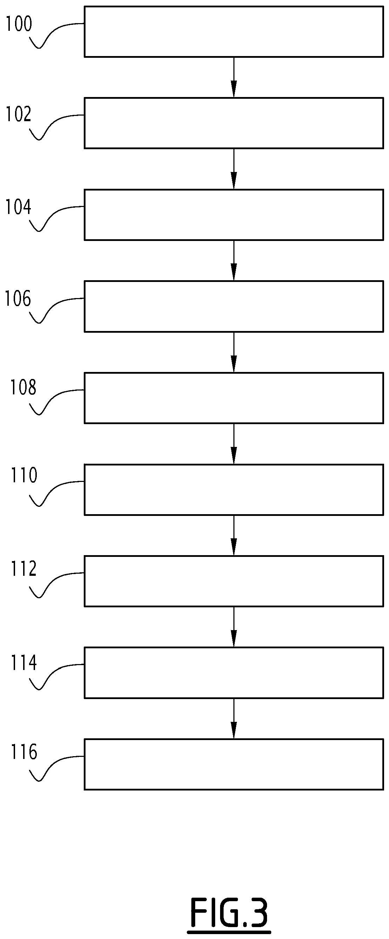

Un exemple de mise en oeuvre de la méthode de détection d'un déclenchement est décrit en détail ci-dessous en référence à la figure 3, qui représente un diagramme de blocs des étapes de cette méthode.

Cependant, en variante, les étapes pourraient être exécutées dans un ordre différent. Certaines étapes pourraient être omises. L'exemple décrit ne fait pas obstacle à ce que, dans d'autres modes de réalisation, d'autres étapes soient mises en oeuvre conjointement et/ou séquentiellement avec les étapes décrites.

Tout d'abord, avant que le dispositif de détection 6 soit en mesure de détecter un déclenchement, une phase d'apprentissage est de préférence mise en place pour que le dispositif de détection 6 reconnaisse la signature acoustique associée au déclenchement d'un ou de plusieurs des appareils de protection présents dans l'armoire 1.

Dans une première étape 100, chaque appareil de coupure 2 est testé pour simuler un défaut électrique en lui injectant un courant de coupure prédéterminé correspondant à son calibre en courant. Le dispositif 6 enregistre, grâce à son microphone 12, le bruit généré par l'appareil 2 à la coupure (signal du bruit de coupure), c'est-à-dire lorsque l'appareil 2 passe de l'état fermé vers l'état ouvert. En particulier, une réponse temporelle et une réponse fréquentielle du bruit sont acquises.

Le processus d'acquisition du bruit généré par l'appareil 2 peut comporter une étape de filtrage et d'extraction pour différencier le son émis par l'appareil du bruit ambiant.

De préférence, la première étape 100 est mise en oeuvre en simulant plusieurs types de défauts électriques, tel qu'une coupure en surcharge, une coupure due à un courant différentiel et une coupure en court-circuit, de manière à récolter des réponses temporelles et fréquentielles pour chaque courant de coupure et chaque type de défaut.

Dans une deuxième étape 102, les signaux du bruit de coupure précédemment acquis sont envoyés à un système d'apprentissage automatique, tel qu'un réseau de neurones.

Par exemple, le système d'apprentissage automatique peut être implémenté par l'unité de commande 8 du dispositif de détection 6, et/ou par un système informatique extérieur au dispositif de détection 6, ce système informatique pouvant néanmoins être en communication avec le dispositif de détection 6. De préférence, le système d'apprentissage automatique est un système d'apprentissage supervisé.

De façon générale, le système d'apprentissage automatique vise à reconnaître la signature acoustique (réponse temporelle et réponse fréquentielle) de chaque appareil de coupure 2 de l'armoire électrique 1, de préférence pour chaque type de défaut et/ou de calibre de coupure.

Pour ce faire, le système d'apprentissage automatique peut définir un ou plusieurs attributs statistiques à partir de chaque signal de bruit de coupure acquis. La définition des attributs permet de caractériser le bruit des appareils de coupure 2 afin de pouvoir, par la suite, reconnaître et isoler ces signatures des autres bruits (bruit ambiant, bruit de commutation des appareils de commutation 4).

En d'autres termes, la signature acoustique de chaque appareil 2, pour chaque type de défaut et/ou de calibre de coupure, est définie par un ou plusieurs attributs statistiques.

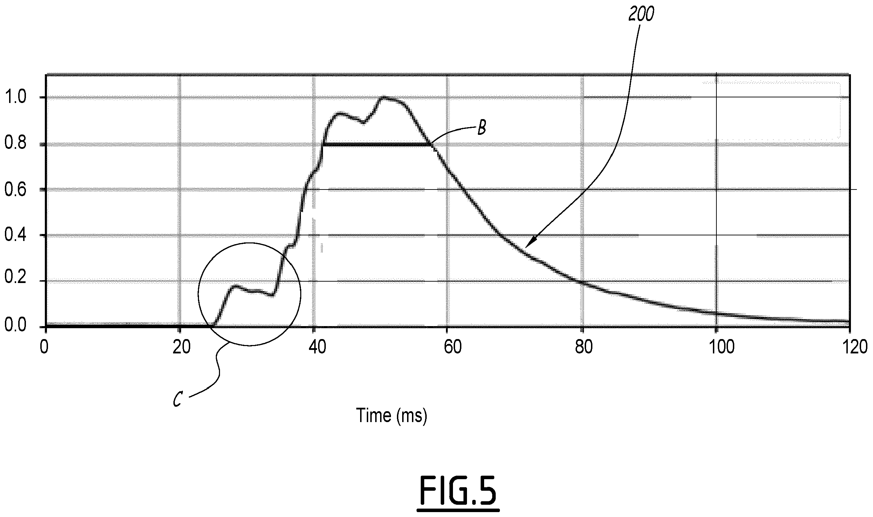

Des exemples d'attributs statistiques seront décrits dans la suite en référence aux figures 5 à 7.

Les signatures acoustiques ainsi acquises peuvent être enregistrées dans une base de données, qui peut être stockée dans un système informatique séparé.

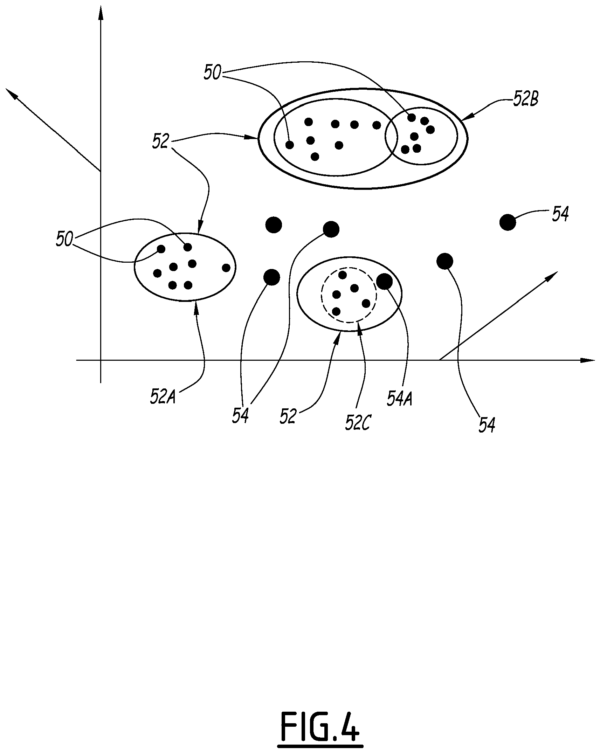

La figure 4 montre un exemple de classification des signatures acoustiques par un réseau de neurones implémenté par le système d'apprentissage automatique.

Par exemple, le système d'apprentissage donne en sortie des valeurs discrètes qui caractérisent un bruit de coupure, qui sont positionnées dans un espace à plusieurs dimensions. La figure 4 montre un système de référence à plusieurs dimensions où des points 50 symbolisent des valeurs qui caractérisent des bruits de coupure de différents appareils de coupure 2, pour différents courants de coupure. Chaque appareil de coupure 2 est analysé pour différents courant de coupure, comme mentionné ci-dessus.

Dans une troisième étape 104, un traitement qui génère un regroupement des valeurs discrètes est exécuté, de manière à créer des catégories de prise de décision 52. Par exemple, une première catégorie 52A regroupe les valeurs représentatives d'un bruit de coupure en surcharge des appareils de calibre mineur de 120A, une deuxième catégorie 52B regroupe les valeurs représentatives d'un bruit de coupure en court-circuit des appareils de calibre compris entre 160A et 630A, etc.

Avantageusement, pendant la phase d'apprentissage, des étapes similaires aux étapes 100 à 104 peuvent être mises en oeuvre cette fois avec les appareils de commutation 4 présents dans l'armoire 1, tels que les contacteurs et les télérupteurs, dans le but que le dispositif de détection 6 apprenne à ne pas détecter la commutation de ces appareils.

Ainsi, dans une quatrième étape 106, chaque appareil de commutation 4 est testé en lui injectant un courant prédéterminé pour le faire commuter et enregistrer le bruit généré par l'appareil 4 à la commutation (signal du bruit de commutation) au moyen du microphone 12.

L'étape précédente est faite de manière à récolter des réponses temporelles et fréquentielles pour chaque commutation à un courant donné.

Dans une cinquième étape 108, les signaux de bruit de commutation précédents sont discrétisés en les envoyant à un système d'apprentissage automatique, de préférence le même que celui déjà utilisé dans la deuxième étape 102, pour obtenir des valeurs de commutation discrètes, comme décrit ci-dessus, afin d'enrichir la base de données déjà construite grâce aux étapes 100 à 104. Dans la figure 4, les points 54 représentent des valeurs de bruits de commutation de différents appareils de commutation 4.

Dans une sixième étape 110, une discrimination des valeurs de commutation discrètes des valeurs de coupure discrètes est exécutée, cette étape consistant à discriminer les bruits associés aux appareils de coupure 2 des bruits associés aux appareils de commutation. Chaque valeur de commutation qui correspond à un bruit de commutation et qui rentre dans une catégorie de prise de décision 52 génère un ajustement de la catégorie de prise de décision 52 de manière à l'exclure.

Sur la figure 4, par exemple, le point 54 rentrant dans le périmètre d'une catégorie 52 engendre une modification selon lequel le volume de la catégorie concerné est réduit de manière à exclure le point, tout en obtenant une catégorie réduite 52C.

Les catégories de prise de décision 52 sont donc liées et représentent la signature acoustique du déclenchement des appareils de coupure 2.

Comme expliqué précédemment, les étapes 100 à 110, font partie d'une première partie de la méthode selon la présente invention, dite phase d'apprentissage.

Dans la suite, une deuxième phase de la méthode selon la présente invention, dite phase de détections, sera décrite. Les étapes appartenant à cette deuxième phase sont mises en oeuvre lors du fonctionnement réel du dispositif de détection 6 dans l'installation 1 et sont par exemple mises en oeuvre par le dispositif de détection 6 lui-même.

On comprend notamment que les étapes de la deuxième phase du procédé peuvent être mises en oeuvre séparément de la phase d'apprentissage. Par exemple, les étapes 100 à 110 peuvent être remplacées par l'acquisition d'une base de données préconfigurée.

Dans une étape 112, l'unité de commande électronique 8 acquiert, au travers du microphone 12, un signal de bruit d'appareil généré par un des appareils de coupure 2 ou de commutation 4 de l'armoire électronique 1.

Par exemple, le dispositif de détection 6 enregistre en continu les bruits dans l'armoire 1 au moyen du microphone 12. Les bruits peuvent être enregistrés pendant une succession d'intervalles de temps successifs.

Dans une étape 114, le signal de bruit d'appareil acquis est discrétisé en l'envoyant au réseau de neurones et la valeur obtenue est comparée avec les catégories de prise de décision 52, définies dans la base de données issue de l'apprentissage.

Si la valeur obtenue rentre dans une catégorie de prise de décision 52, l'unité de commande électronique 8 envoie, dans une étape 116, un signal d'alarme à l'interface de communication radio 10 qui, à son tour, transmet un signal d'alerte. De préférence, le signal d'alerte est transmis à un appareil portable d'un client.

De préférence, l'unité de commande électronique 8 est capable de discriminer entre les catégories de prise de décision 52. Dans ce cas, elle envoie aussi à l'interface de communication radio 10 un signal représentatif d'une catégorie du défaut. Le signal d'alerte contient aussi cette information du signal de catégorie. Grâce à cette information, le client est à même de répondre au degré d'urgence et d'intervenir rapidement si c'est nécessaire.

Avantageusement, la base de données issue de l'apprentissage peut être mise à jour lors du fonctionnement de l'appareil 6.

Par exemple, si une fausse alerte est envoyée, le bruit qui l'a généré est utilisé pour modifier les catégories de prise de décision 52, en répétant la phase d'apprentissage et donc les étapes 106 à 110 de la méthode. Par exemple, un utilisateur qui s'est déplacé pour inspecter l'armoire 1 suite à une fausse alerte peut indiquer sur son appareil portable qu'il s'agissait d'une fausse alerte. Le dispositif de détection 6 acquiert cette information et met à jour la base de données, par exemple en changeant des propriétés associées aux attributs statistiques de la signature acoustique concernée.

Avantageusement, il est possible de rajouter des sons spécifiques au déclenchement d'un appareil de coupure 2, afin de le classifier en fonction de la criticité.

Par exemple, un des appareils de coupure 2 présentant une importance critique est équipés, dans l'armoire électrique, d'un dispositif mécanique ou autre, tel qu'une cloche, de manière à émettre un son spécifique lors de la commutation, ce son spécifique étant différent du son émis par les autres appareils de l'armoire. Ce son spécifique est préalablement appris par le dispositif de détection 6 par entrainement, comme décrit dans les étapes ci-dessus.

De façon générale, pour bien caractériser les bruits des appareils de coupure 2, des attributs statistiques de ces bruits sont définis, afin de les caractériser pour les isoler des autres bruits.

Cette étape consiste à analyser la réponse temporelle et/ou la réponse fréquentielle du bruit afin d'en extraire des caractéristiques spécifiques à l'appareil de coupure 2.

Les figures 5 à 7 sont des graphes représentant chacun un exemple de bruit de déclenchement d'un appareil de coupure enregistré par le dispositif de détection 6 et sur lesquels sont définis différents attributs statistiques.

Sur la figure 5, on peut voir un paramètre B (ou attribut B) sur la courbe temporelle 200 représentant l'amplitude sonore du signal enregistré en fonction du temps. Le paramètre B représente la durée (ms) pendant laquelle l'intensité du signal de bruit de coupure reste supérieure à 80% de l'intensité maximale du signal de bruit de coupure.

Toujours sur la figure 5, on peut voir une caractéristique propre aux disjoncteurs différentiels. Sur les disjoncteurs différentiels, cette forme apparait souvent, et elle a pour origine le mouvement d'une pièce « *folle* » présente dans la chaine cinématique. Pour caractériser cet aspect particulier du signal, on peut définir un attribut C sur la courbe temporelle, cet attribut C représentant un point d'inflexion mesuré 25ms avant l'atteinte des 80% de l'intensité du signal de bruit de coupure. L'amplitude de l'inflexion doit préférentiellement être supérieur à 1,5% de l'intensité du signal de bruit de coupure.

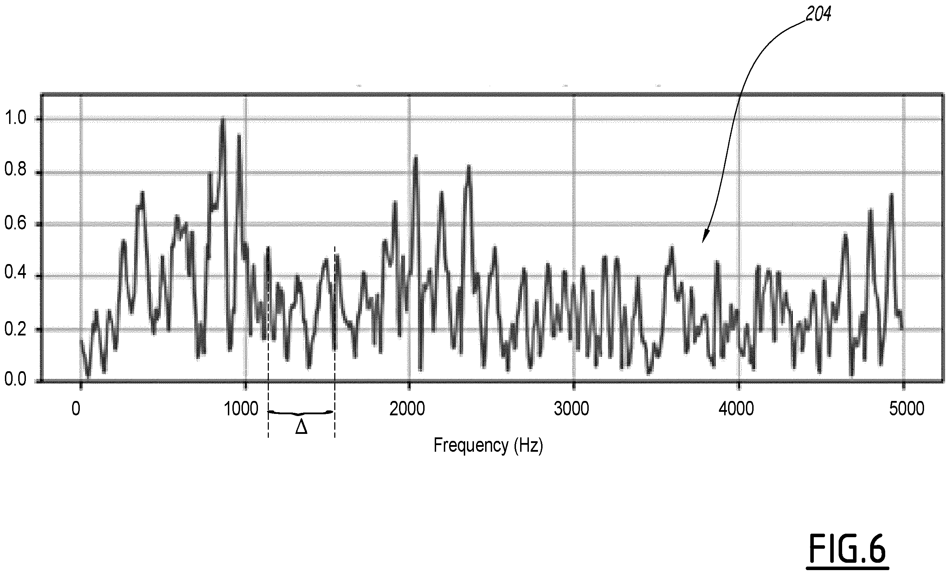

Sur la figure 6, on peut voir une courbe fréquentielle 204 représentant l'amplitude sonore du signal enregistré dans le domaine fréquentiel, et on peut définir un attribut fréquentiel représentatif d'une gamme de fréquence Δ propice aux contacteurs, cet attribut fréquentiel étant une mesure de la fréquence lors de la première atteinte du 100 % de l'intensité du signal de bruit de coupure ou une moyenne d'intensité du signal de bruit de coupure plus grande de 46%.

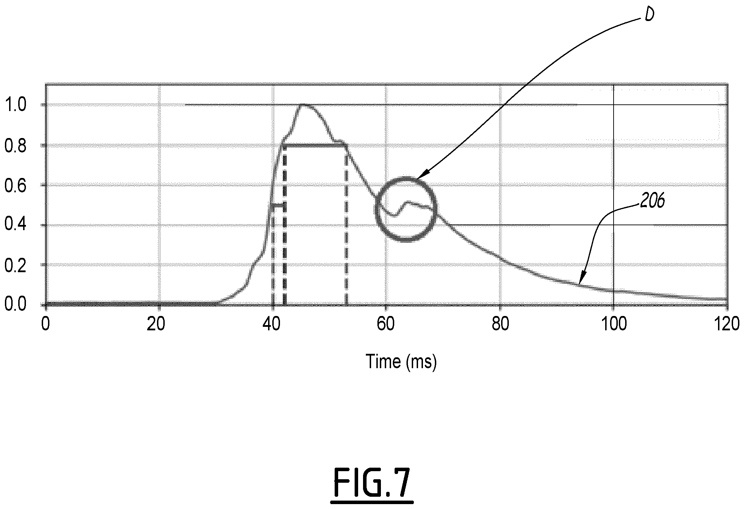

Sur la figure 7, on peut voir un paramètre D sur la « *queue* » du signal temporel 206 qui est la mesure « *d'un rebond* » , inflexion propre au bruit d'un contacteur .

## Revendications

1. Méthode de détection du déclenchement d'un appareil de coupure dans une armoire électrique (1), cette armoire électrique (1) comprenant au moins un appareil de coupure du courant électrique (2) et au moins un appareil de commutation du courant électrique (4), la méthode comprenant une phase d'apprentissage apte à générer des catégories de prise de décision (52) associées à une signature acoustique du déclenchement dudit au moins un appareil de coupure (2), et une phase de détection du déclenchement de l'appareil de coupure (2) comprenant des étapes consistant à :
- acquérir (112) un signal de bruit d'appareil généré par au moins un desdits appareils de coupure du courant électrique (2) ou au moins un appareil de commutation du courante électrique (4), et
- comparer (114) dudit signal de bruit d'appareil avec lesdites catégories de prise de décision (52) pour détecter si le signal du bruit d'appareil correspond au déclenchement de l'appareil de coupure (2), la méthode de détection étant **caractérisée en ce que** la phase d'apprentissage comprend des étapes consistant à :
- injecter (100) dans l'appareil de coupure (2) un courant de coupure prédéterminé et enregistrer le signal du bruit de coupure généré,
- envoyer (102) le signal du bruit de coupure à un système d'apprentissage automatique apte à reconnaître la signature acoustique de l'appareil de coupure (2) en donnant en sortie des valeurs de coupure discrètes,
- regrouper (104) les valeurs de coupure discrètes de manière à créer les catégories de prise de décision (52),
- injecter (106) dans l'appareil de commutation (4) un courant prédéterminé et enregistrer le signal du bruit de commutation généré,
- envoyer (108) le signal du bruit de commutation au système d'apprentissage automatique et obtenir en sortie des valeurs de commutation discrètes,
- discriminer (110) les valeurs de commutation discrètes des valeurs de coupure discrètes en modifiant les catégories de prise de décision (52) de manière à exclure les valeurs de commutation discrètes qui rentrent dans ces catégories de prise de décision (52).

2. Méthode selon la revendication 1, dans laquelle le système d'apprentissage est un réseau de neurones.

3. Méthode de détection selon l'une quelconque des revendications précédentes, dans laquelle la phase de détection comprend discrétiser le signal du bruit d'appareil acquis et comparer la valeur obtenue avec les catégories de prise de décision (52) et si la valeur obtenue rentre dans une catégorie de prise de décision (52), envoyer un signal d'alarme.

4. Méthode de détection selon la revendication 3, dans laquelle lorsqu'un signal d'alarme est envoyé alors qu'aucun déclenchement ne s'est produit, le bruit enregistré à l'origine de l'alarme est utilisé pour modifier les catégories de prise de décision (52).

5. Méthode de détection selon l'une quelconque des revendications précédentes, dans laquelle l'étape d'injection (100) dans l'appareil de coupure (2) d'un courant de coupure comprend l'injection d'un courant de coupure en surcharge, l'injection d'un courant différentiel et l'injection d'un courant de coupure en court-circuit pour simuler différents types de défauts électriques.

6. Méthode de détection selon l'une quelconque des revendications précédentes, dans laquelle le système d'apprentissage automatique définit au moins un attribut statistique du signal de bruit de coupure acquis pour caractériser le bruit de l'appareil de coupure (2).

7. Méthode de détection selon la revendication 6, dans laquelle un ou plusieurs des attributs statistiques sont choisis dans le groupe comprenant :
- la durée pendant laquelle l'intensité du signal de bruit de coupure reste supérieure à un pourcentage prédéterminé de l'intensité maximale du signal de bruit de coupure,
- un point d'inflexion mesuré à un instant de temps prédéterminé avant l'atteinte d'un pourcentage Prédéterminé de l'intensité maximale du signal de bruit de coupure,
- une gamme de fréquence (Δ) correspondant à une mesure de l'instant de la première atteinte du 100% de l'intensité du signal de bruit de coupure, ou une moyenne d'intensité du signal de bruit de coupure plus grande d'un pourcentage prédéterminé de l'intensité maximale du signal de bruit de coupure, et
- une mesure de l'instant de la première atteinte du 100 % de l'intensité du signal de bruit de coupure.

8. Méthode de détection selon l'une quelconque des revendications précédentes, dans laquelle le signal de bruit d'appareil est acquis en continu.

9. Méthode de détection selon l'une quelconque des revendications précédentes, dans laquelle un des appareils de coupure (2) est modifié pour produire un son spécifique lors du déclenchement, ce son spécifique étant préalablement appris dans la phase d'apprentissage.

10. Dispositif de détection (6) du déclenchement d'un appareil de coupure (2) dans une armoire électrique (1) comprenant au moins un appareil de coupure du courant électrique (2) et au moins un appareil de commutation du courant électrique (4), le dispositif de détection (6) comprenant une unité de commande électronique (8) configurée pour exécuter la méthode de détection du déclenchement selon l'une quelconque des revendications précédentes, une interface de communication (10) connectée avec l'unité de commande électronique (8) apte à émettre un signal d'alerte, et un microphone (12) connecté avec l'unité de commande électronique (8) apte à acquérir le signal de bruit d'appareil, le signal de bruit de coupure et le signal de bruit de commutation.

11. Armoire électrique (1) comprenant un dispositif (6) selon la revendication 10 installé à l'intérieur de l'armoire électrique (1), en haut d'une colonne de l'armoire (1).

12. Armoire électrique (1) comprenant plusieurs colonnes, chaque colonne étant équipée d'un dispositif de détection (6) selon la revendication 10, installé en haut de l'armoire, avec le microphone (12) déporté vers une zone à surveiller.

13. Armoire électrique (1) comprenant plusieurs colonnes où une seule colonne est équipée d'un dispositif de détection (6) selon la revendication 10, placé en haut de l'armoire (1), avec une pluralité de microphones (12) déportés vers des zones à surveiller dans chaque colonne.

14. Armoire électrique (1) comprenant plusieurs colonnes dont certaines sont compartimentées, chaque compartiment comprenant un dispositif de détection (6) selon la revendication 10.

## Patentansprüche

1. Verfahren zur Erfassung der Auslösung eines Abschaltgeräts in einem Schaltschrank (1), wobei dieser Schaltschrank (1) mindestens ein Abschaltgerät zur Unterbrechung des elektrischen Stroms (2) und mindestens ein Gerät zum Schalten des elektrischen Stroms (4) umfasst, wobei das Verfahren eine Lernphase umfasst, die geeignet ist, um Entscheidungsfindungskategorien (52) zu erzeugen, die mit einer akustischen Signatur der Auslösung des mindestens einen Abschaltgeräts (2) verbunden sind, und eine Phase der Erfassung der Auslösung des Abschaltgeräts (2), die Schritte umfasst, die aus Folgendem bestehen:
- Erfassen (112) eines Geräterauschsignals, das von mindestens einem der Geräte zur Unterbrechung des elektrischen Stroms (2) oder mindestens einem Gerät zum Schalten des elektrischen Stroms (4) erzeugt wird, und
- Vergleichen (114) des Geräterauschsignals mit den Entscheidungsfindungskategorien (52), um zu erfassen, ob das Signal des Geräterauschens dem Auslösen des Abschaltgeräts (2) entspricht, wobei das Erfassungsverfahren **dadurch gekennzeichnet ist, dass** die Lernphase die folgenden Schritte umfasst:
- Injizieren (100) eines vorbestimmten Abschaltstroms in das Abschaltgerät (2) und Aufzeichnen des Signals des erzeugten Abschaltrauschens,
- Senden (102) des Signals des Abschaltgeräuschs an ein automatisches Lernsystem, das in der Lage ist, die akustische Signatur des Abschaltgeräts (2) zu erkennen, indem es am Ausgang diskrete Abschaltwerte angibt,
- Gruppieren (104) der diskreten Abschaltwerte, um die Entscheidungsfindungskategorien (52) zu erstellen,
- Injizieren (106) eines vorbestimmten Stroms in das Schaltgerät (4) und Aufzeichnen des Signals des erzeugten Schaltgeräuschs,
- das Signal des Schaltgeräuschs an das automatische Lernsystem senden (108) und diskrete Schaltwerte am Ausgang erhalten,
- Unterscheiden (110) diskreter Schaltwerte von diskreten Abschaltwerten durch Modifizieren der Entscheidungsfindungskategorien (52), um diskrete Schaltwerte, die in diese Entscheidungsfindungskategorien (52) passen, auszuschließen.

2. Verfahren nach Anspruch 1, bei dem das Lernsystem ein neuronales Netz ist.

3. Erfassungsverfahren nach einem der vorhergehenden Ansprüche, wobei die Erfassungsphase das Diskretisieren des erfassten Geräterauschsignals und das Vergleichen des erhaltenen Werts mit Entscheidungsfindungskategorien (52) umfasst, und wenn der erhaltene Wert in eine Entscheidungsfindungskategorie (52) fällt, das Senden eines Alarmsignals.

4. Erfassungsverfahren nach Anspruch 3, bei dem, wenn ein Alarmsignal gesendet wird, obwohl keine Auslösung stattgefunden hat, das aufgezeichnete Rauschen, das den Alarm verursacht hat, verwendet wird, um die Entscheidungsfindungskategorien (52) zu modifizieren.

5. Erfassungsverfahren nach einem der vorhergehenden Ansprüche, wobei der Schritt des Injizierens (100) in das Abschaltgerät (2) eines Abschaltstroms die Einspeisung eines Überlast-Abschaltstroms, die Einspeisung eines Differenzstroms und die Einspeisung eines Kurzschluss-Abschaltstroms umfasst, um verschiedene Arten von elektrischen Fehlern zu simulieren.

6. Erfassungsverfahren nach einem der vorhergehenden Ansprüche, wobei das automatische Lernsystem mindestens ein statistisches Attribut des erfassten Abschaltgeräuschsignals definiert, um das Rauschen des Abschaltgeräts (2) zu charakterisieren.

7. Erfassungsverfahren nach Anspruch 6, wobei eines oder mehrere der statistischen Attribute aus der Gruppe ausgewählt sind, bestehend aus:
- der Dauer, während der die Intensität des Abschaltgeräuschsignals über einem vorbestimmten Prozentsatz der maximalen Intensität des Abschaltgeräuschsignals bleibt,
- einem Wendepunkt, der zu einem vorbestimmten Zeitpunkt vor dem Erreichen eines vorbestimmten Prozentsatzes der maximalen Intensität des Abschaltgeräuschsignals gemessen wird,
- einem Frequenzbereich (Δ), der einer Messung des Zeitpunkts des ersten Erreichens von 100 % der Intensität des Abschaltgeräuschsignals entspricht, oder einer durchschnittlichen Intensität des Abschaltgeräuschsignals, die um einen vorbestimmten Prozentsatz der maximalen Intensität des Abschaltgeräuschsignals größer ist, und
- einer Messung des Zeitpunkts des ersten Erreichens von 100 % der Signalstärke des Abschaltgeräuschs.

8. Erfassungsverfahren nach einem der vorhergehenden Ansprüche, bei dem das Geräterauschsignal kontinuierlich erfasst wird.

9. Erfassungsverfahren nach einem der vorhergehenden Ansprüche, bei dem eines der Abschaltgeräte (2) so verändert wird, dass es beim Auslösen einen bestimmten Ton erzeugt, wobei dieser bestimmte Ton zuvor in der Lernphase erlernt wurde.

10. Erfassungsvorrichtung (6) für die Auslösung eines Abschaltgeräts (2) in einem Schaltschrank (1), der mindestens ein Abschaltgerät zur Unterbrechung des elektrischen Stroms (2) und mindestens ein Gerät zum Schalten des elektrischen Stroms (4) umfasst, wobei die Erfassungsvorrichtung (6) eine elektronische Steuereinheit (8) umfasst, die so konfiguriert ist, dass sie das Verfahren zum Erfassen der Auslösung nach einem der vorgehenden Ansprüche ausführt, eine Kommunikationsschnittstelle (10), die mit der elektronischen Steuereinheit (8) verbunden ist und in der Lage ist, ein Warnsignal zu senden und ein Mikrofon (12), das mit der elektronischen Steuereinheit (8) verbunden ist und das Geräterauschsignal, das Abschaltgeräuschsignal und das Schaltgeräusch erfassen kann.

11. Schaltschrank (1) mit einer Vorrichtung (6) nach Anspruch 10, die im Inneren des Schaltschranks (1) oben auf einer Spalte des Schaltschranks (1) installiert ist.

12. Schaltschrank (1) mit mehreren Spalten, wobei jede Spalte mit einer Erfassungsvorrichtung (6) nach Anspruch 10 ausgestattet ist, die oben im Schrank installiert ist, wobei das Mikrofon (12) in Richtung eines zu überwachenden Bereichs versetzt ist.

13. Schaltschrank (1) mit mehreren Spalten, wobei eine einzelne Spalte mit einer Erfassungsvorrichtung (6) nach Anspruch 10 ausgestattet ist, die oben auf dem Schaltschrank (1) angebracht ist, mit einer Vielzahl von Mikrofonen (12), die zu den zu überwachenden Bereichen in jeder Spalte versetzt sind.

14. Schaltschrank (1) mit mehreren Spalten, von denen einige unterteilt sind, wobei jedes Fach eine Erfassungsvorrichtung (6) nach Anspruch 10 umfasst.

## Claims

1. A method of detecting tripping of an interrupting apparatus in an electrical cabinet (1), said electrical cabinet (1) comprising at least one electrical current interrupting apparatus (2) and at least one electrical current switching apparatus (4), the method comprising a learning phase suitable for generating decision-making categories (52) associated with an acoustic signature of the tripping of said at least one switching device (2), and a phase of detecting the tripping of the switching device (2) comprising steps consisting of:
- acquiring (112) a device noise signal generated by at least one of said electrical current switching devices (2) or at least one electrical current switching device (4), and
- comparing (114) said device noise signal with said decision making categories (52) to detect whether the device noise signal corresponds to triggering of the mute device (2), the detection method being **characterised in that** the learning phase comprises steps of:
- injecting (100) a predetermined switching current into the switching device (2) and recording the switching noise signal generated,
- sending (102) the mute noise signal to an automatic learning system capable of recognising the acoustic signature of the mute device (2) and outputting discrete mute values,
- grouping (104) the discrete cut-off values to create the decision-making categories (52),
- injecting (106) a predetermined current into the switching device (4) and recording the switching noise signal generated,
- sending (108) the switching noise signal to the automatic learning system and obtaining discrete switching values as an output,
- discriminating (110) between discrete switching values and discrete cut-off values by modifying the decision making categories (52) so as to exclude discrete switching values which fall into those decision making categories (52).

2. The method of claim 1, wherein the learning system is a neural network.

3. A detection method according to any one of the preceding claims, wherein the detection phase comprises discretising the acquired device noise signal and comparing the value obtained with decision making categories (52) and if the value obtained falls within a decision making category (52), sending an alarm signal.

4. A detection method according to claim 3, in which when an alarm signal is sent even though no triggering has occurred, the noise recorded at the origin of the alarm is used to modify the decision-making categories (52).

5. A detection method according to any one of the preceding claims, in which the step of injecting (100) into the switching device (2) a switching current comprises injecting an overload switching current, injecting a differential current and injecting a short-circuit switching current in order to simulate different types of electrical faults.

6. A detection method according to any one of the preceding claims, in which the automatic learning system defines at least one statistical attribute of the acquired cut-off noise signal in order to characterise the noise of the cut-off device (2).

7. The detection method of claim 6, wherein one or more of the statistical attributes is selected from the group consisting of:
- the duration during which the intensity of the cut-off noise signal remains greater than a predetermined percentage of the maximum intensity of the cut-off noise signal,
- an inflection point measured at a predetermined instant of time before a predetermined percentage of the maximum intensity of the cut-off noise signal is reached,
- a frequency range (Δ) corresponding to a measurement of the time of first reaching 100% of the cut-off noise signal strength, or an average cut-off noise signal strength greater than a predetermined percentage of the maximum cut-off noise signal strength, and
- a measurement of the time at which 100% of the cut-off noise signal intensity was first reached.

8. A detection method according to any of the preceding claims, in which the device noise signal is acquired continuously.

9. A detection method according to any one of the preceding claims, in which one of the switching devices (2) is modified to produce a specific sound when triggered, this specific sound being previously learned in the learning phase.

10. Device (6) for detecting the tripping of a switching device (2) in an electrical cabinet (1) comprising at least one electrical current switching device (2) and at least one electrical current switching device (4), the detection device (6) comprising an electronic control unit (8) configured to perform the tripping detection method according to any one of the preceding claims, a communication interface (10) being connected to the electronic control unit (8) capable of emitting an alert signal, and a microphone (12) connected to the electronic control unit (8) capable of acquiring the device noise signal, the cut-off noise signal and the switching noise signal.

11. Electrical cabinet (1) comprising a device (6) according to claim 10 installed inside the electrical cabinet (1), at the top of a column of the cabinet (1).

12. Electrical cabinet (1) comprising several columns, each column being equipped with a detection device (6) according to claim 10, installed at the top of the cabinet, with the microphone (12) offset towards a zone to be monitored.

13. Electrical cabinet (1) comprising several columns, where a single column is equipped with a detection device (6) according to claim 10, placed at the top of the cabinet (1), with a plurality of microphones (12) offset towards zones to be monitored in each column.

14. Electrical cabinet (1) comprising several columns, some of which are compartmentalised, each compartment comprising a detection device (6) according to claim 10.
